# EUROPEAN PATENT APPLICATION

(11) **EP 4 641 930 A1**
(43) Date of publication of application: **29.10.2025**
(21) Application number: 24744167.8
(22) Date of filing: 11.01.2024
(51) Int. Cl.: H03L 7/099, H03L 7/097, H03L 7/089

(54) **OSCILLATION CIRCUIT, OSCILLATION CONTROL METHOD, PHASE LOCKED LOOP CIRCUIT AND ELECTRONIC DEVICE**

(30) Priority: 18.01.2023 CN 202310089155
(71) Applicant: Huawei Technologies Co., Ltd., Shenzhen, Guangdong 518129 (CN)
(72) Inventor: SHI, Kai, Shenzhen, Guangdong 518129 (CN)
(74) Representative: Goddar, Heinz J.
(86) International application number: PCT/CN2024/071868
(87) International publication number: WO 2024/152991

(57) **Abstract**

Embodiments of this application provide an oscillation circuit, an oscillation control method, a phase-locked loop circuit, and an electronic device. An amplitude comparison circuit, a voltage control circuit, an adjustable power source, and an oscillator are disposed in the oscillation circuit. In the first time period, an amplitude of an oscillation signal is obtained, and a first control voltage is generated based on the amplitude; and then the first control voltage presenting when the amplitude is constant is obtained as a target control voltage, and is stored. After the first time period, during subsequent operation of the oscillator, the voltage control circuit controls, by using the target control voltage, the adjustable power source to output a power supply voltage, and power is supplied to the oscillator at the power supply voltage. In embodiments of this application, due to the target control voltage, an amplitude and an oscillation frequency of the oscillator can be kept relatively stable while the oscillator is rapidly stabilized.

## Description

This application claims priority to Chinese Patent Application No. 202310089155.6, filed with the China National Intellectual Property Administration on January 18, 2023 and entitled "OSCILLATION CIRCUIT, OSCILLATION CONTROL METHOD, PHASE-LOCKED LOOP CIRCUIT, AND ELECTRONIC DEVICE", which is incorporated herein by reference in its entirety.

### TECHNICAL FIELD

This application relates to the field of electronic technologies, and in particular, to an oscillation circuit, an oscillation control method, a phase-locked loop circuit, and an electronic device.

### BACKGROUND

Phase-locked loops (phase locked loops, PLLs) are commonly used in communication systems. A core component of the phase-locked loop is an oscillator (oscillator). The phase-locked loop is a negative feedback control system that tunes the oscillator using a voltage generated by phase synchronization, to generate a target frequency. Because the oscillator is a damped oscillation system, an oscillation amplitude of the oscillator exhibits a variation process, from start of oscillation to stabilization of oscillation. In the variation process, a frequency of the oscillator also varies. Only when the frequency of the oscillator is in a stable stage, the phase-locked loop can operate normally. Therefore, a prolonged process of the oscillator from the start of oscillation to the stabilization of oscillation is a significant limiting factor that affects rapid operation of the phase-locked loop.

### SUMMARY

Embodiments of this application provide an oscillation circuit, an oscillation control method, a phase-locked loop circuit, and an electronic device, to implement rapid stabilization of an oscillator.

To achieve the foregoing objective, the following technical solutions are used in embodiments of this application.

According to a first aspect, an oscillation circuit is provided, where the oscillation circuit includes an oscillator, an amplitude comparison circuit, a voltage control circuit, and an adjustable power source, the adjustable power source is coupled to the oscillator, the amplitude comparison circuit is separately coupled to the oscillator and the adjustable power source, and the voltage control circuit is separately coupled to the amplitude comparison circuit and the adjustable power source;
the adjustable power source is configured to provide an input signal for the oscillator; the oscillator is configured to output an oscillation signal based on the input signal;
in a first time period: the amplitude comparison circuit is configured to output a first control voltage to the adjustable power source based on an amplitude of the oscillation signal and a reference voltage, where the first control voltage is used to control the adjustable power source to adjust the input signal; and the voltage control circuit is configured to obtain a target control voltage, where the target control voltage is the first control voltage presenting when the amplitude of the oscillation signal of the oscillator is stabilized in the first time period; and
after the first time period: the voltage control circuit is configured to control, by using the target control voltage, the adjustable power source to adjust the input signal.

For example, first, in the first time period, the amplitude comparison circuit controls, in a closed-loop power supply manner, the adjustable power source to output a power supply voltage to the oscillator, which is specifically: The amplitude comparison circuit obtains the amplitude of the oscillation signal, adjusts a voltage value of the output first control voltage based on the amplitude of the oscillation signal, and adjusts, by using the first control voltage, a value of the power supply voltage output by the adjustable power source, until the amplitude of the oscillation signal is constant. In this case, the first control voltage is the target control voltage. Then, after the first time period, the voltage control circuit is controlled to obtain the first control voltage that is correspondingly the target control voltage. When the oscillator is powered on or off or a PVT varies subsequently, the voltage control circuit controls, in an open-loop power supply manner, the adjustable power source to output the power supply voltage to the oscillator, which is specifically: The voltage control circuit controls, based on the obtained target control voltage by using the constant target control voltage, the voltage value of the power supply voltage output by the adjustable power source to the oscillator.

In this embodiment of this application, when the oscillator oscillates to operate for the first time, the amplitude of the oscillation signal is obtained in the closed-loop power supply manner, to obtain the first control voltage that is the target control voltage. The first control voltage causes the adjustable power source to output the power supply voltage to the oscillator. The power supply voltage causes the amplitude of the oscillation signal to be constant. Then, the voltage control circuit obtains the target control voltage, and during subsequent operation of the oscillator, controls, by using the constant target control voltage, the adjustable power source to generate the power supply voltage, to drive the oscillator by using the power supply voltage. Due to the power supply voltage generated by using the target control voltage, there is no need to repeatedly determine the power supply voltage in the closed-loop power supply manner during subsequent operation of the oscillator, to stabilize the amplitude of the oscillation signal at a specific amplitude or within a specific amplitude range. In this embodiment of this application, in this implementation, when the amplitude of the oscillation signal is relatively stable, the oscillator can be rapidly stabilized, so that a phase-locked loop circuit can also be rapidly locked.

In a possible implementation, the amplitude comparison circuit includes an amplitude detection circuit and a first operational amplifier, an input of the amplitude detection circuit is coupled to an output of the oscillator, an output of the amplitude detection circuit is coupled to a first input of the first operational amplifier, a second input of the first operational amplifier is configured to input a reference voltage, and an output of the first operational amplifier is coupled to a controlled end of the adjustable power source; and in the first time period: the amplitude detection circuit is configured to output an amplitude voltage based on the amplitude of the oscillation signal; and the first operational amplifier is configured to output the first control voltage based on the amplitude voltage and the reference voltage.

In this embodiment of this application, the amplitude detection circuit detects the amplitude of the oscillation signal, and generates the corresponding amplitude voltage based on a value of the amplitude. Next, the amplitude voltage and the reference voltage are input to the first operational amplifier, and the first operational amplifier compares a value of the amplitude voltage with a value of the reference voltage. When the amplitude voltage is equal to or close to the reference voltage (which indicates that the amplitude in this case is a required amplitude), the first operational amplifier generates the first control voltage. The adjustable power source is controlled based on the first control voltage to generate the power supply voltage, to supply power to the oscillator at the power supply voltage, so that the amplitude of the oscillation signal is stabilized. Then, the voltage control circuit obtains the first control voltage. The first control voltage is the target control voltage.

In a possible implementation, the amplitude comparison circuit further includes a gain adjustment circuit, the gain adjustment circuit includes a first transistor, a first electrode of the first transistor is coupled to a voltage end of the first operational amplifier, a gate of the first transistor is coupled to the output of the first operational amplifier, and a second electrode of the first transistor is coupled to the second input of the first operational amplifier.

In this embodiment of this application, an output gain of the first operational amplifier is adjusted through the first transistor, so that a gain of the amplitude comparison circuit is improved.

In a possible implementation, the gain adjustment circuit further includes a second transistor, a first electrode of the second transistor is coupled to the second electrode of the first transistor, a gate of the second transistor is connected to a bias voltage, and a second electrode of the second transistor is grounded.

In this embodiment of this application, a value of a negative feedback voltage signal may be adjusted through the second transistor.

In a possible implementation, the gain adjustment circuit further includes a first resistor, and the second electrode of the first transistor is coupled to the second input of the first operational amplifier through the first resistor.

In this embodiment of this application, the value of the negative feedback voltage signal may be adjusted through the first resistor.

In a possible implementation, the oscillation circuit further includes a reference voltage circuit, the reference voltage circuit is coupled to the second input of the first operational amplifier, and the reference voltage circuit is configured to generate the reference voltage.

In this embodiment of this application, the reference voltage circuit generates the reference voltage, and outputs the reference voltage to the second output of the first operational amplifier. A parameter of the reference voltage circuit is adjusted, so that the reference voltage can be adjusted and therefore the amplitude and the like of the oscillation signal output by the oscillator can be adjusted.

In a possible implementation, the oscillation circuit further includes a test operational amplifier, a first input of the test operational amplifier is coupled to the output of the amplitude detection circuit, and a second input of the test operational amplifier is coupled to an output of the test operational amplifier.

In this embodiment of this application, some additional test functions for the circuit may be implemented through the test operational amplifier.

In a possible implementation, the voltage control circuit includes a second operational amplifier and a comparison processing circuit, a first input of the second operational amplifier is coupled to an output of the amplitude comparison circuit, a second input of the second operational amplifier is coupled to an output of the comparison processing circuit, an output of the second operational amplifier is coupled to an input of the comparison processing circuit, and the output of the comparison processing circuit is coupled to the controlled end of the adjustable power source; the second operational amplifier is configured to: in the first time period, compare the first control voltage with a voltage output by the comparison processing circuit, and output a comparison result to the comparison processing circuit; and the comparison processing circuit is configured to: in the first time period, determine the target control voltage based on the comparison result.

In this embodiment of this application, the second operational amplifier obtains the first control voltage output by the amplitude comparison circuit and the voltage output by the comparison processing circuit; compares, based on set timing, the first control voltage with the voltage output by the comparison processing circuit; and outputs a plurality of comparison results to the comparison processing circuit based on the timing. In the comparison processing circuit, a corresponding voltage value is set for each comparison operation based on the timing, and it may be determined, based on the input comparison result, a value of the target control voltage corresponding to the comparison result under the corresponding timing. For example, comparison results are, each comparison operation corresponds to a corresponding voltage value, and a voltage value corresponding to a first occurrence of a comparison result of is the voltage value corresponding to the target control voltage; or comparison results are, and a voltage value corresponding to a first occurrence of a comparison result of is the voltage value corresponding to the target control voltage.

In a possible implementation, the comparison processing circuit includes a digital signal circuit, a storage unit, a digital-to-analog converter, and a third operational amplifier, an input of the digital signal circuit is coupled to the output of the second operational amplifier, an output of the digital signal circuit is coupled to a storage end of the storage unit, and an output of the storage unit is coupled to an input of the digital-to-analog converter; and in the first time period: the digital signal circuit is configured to output a first digital signal to the storage unit based on the comparison result, where a value of the first digital signal indicates a value of the target control voltage; the storage unit is configured to store the first digital signal; and the digital-to-analog converter is configured to output the target control voltage based on the first digital signal.

In this embodiment of this application, the digital signal circuit determines the voltage value of the target control voltage based on the comparison result, and outputs the first digital signal to the storage unit; and the first digital signal indicates the voltage value of the target control voltage, and is input to the storage unit for storage. Then, during subsequent operation of the oscillator (that is, after the first time period), the storage unit outputs the stored first digital signal to the digital-to-analog converter, and the digital-to-analog converter outputs the target control voltage. When the oscillator is powered on again or the PVT varies, the digital-to-analog converter controls, based on the output target control voltage, the adjustable power source to output the power supply voltage.

In some possible implementations, the comparison processing circuit further includes the third operational amplifier, the output of the digital-to-analog converter is coupled to a first input of the third operational amplifier, an output of the third operational amplifier is coupled to the controlled end of the adjustable power source, and the output of the third operational amplifier is further coupled to a second input of the third operational amplifier.

In this embodiment of this application, the third operational amplifier forms a voltage follower, to cause the value of the target control voltage output by the digital-to-analog converter to be more stable.

In some possible implementations, the oscillation circuit further includes a first switch and a second switch, the amplitude comparison circuit is coupled to the controlled end of the adjustable power source through the first switch, and the voltage control circuit is coupled to the controlled end of the adjustable power source through the second switch; in the first time period, the first switch is turned on and the second switch is turned off; and after the first time period, the first switch is turned off and the second switch is turned on.

In this embodiment of this application, the first switch and the second switch are controlled to be turned on and turned off. In this way, in the first time period, the amplitude comparison circuit outputs the first control voltage to adjust the input signal output by the adjustable power source, and after the first time period, the voltage control circuit outputs the target control voltage to adjust the input signal output by the adjustable power source.

Optionally, the input signal output by the adjustable power source to the oscillator may be a voltage signal or a current signal.

In a possible implementation, the adjustable power source includes a third transistor, a fourth transistor, and a first adjustable resistor; a first end of the first adjustable resistor is separately coupled, as the controlled end of the adjustable power source, to the first switch and the second switch; a second end of the first adjustable resistor is coupled to a gate of the fourth transistor; a first electrode of the fourth transistor is configured to input a voltage; a second electrode of the fourth transistor is coupled to an input of the oscillator; a first end of the third transistor is coupled to the first end of the first adjustable resistor; and a second end of the third transistor is coupled to the second end of the first adjustable resistor.

In this embodiment of this application, different first control voltages or target control voltages are output to the first end of the first adjustable resistor, so that the power supply voltage output to the oscillator through the first electrode and the second electrode of the fourth transistor has different voltage values. In this way, the power supply voltage is adjusted.

In a possible implementation, the oscillation circuit further includes a first power supply circuit, the first power supply circuit is coupled to the first electrode of the fourth transistor, and the first power supply circuit is configured to provide a power supply voltage.

In this embodiment of this application, the first power supply circuit provides the power supply voltage for the adjustable power source.

According to a second aspect, an embodiment of this application further provides an oscillation control method, based on an oscillation circuit, where the oscillation circuit includes a voltage control circuit, an oscillator, and an adjustable power source, and the method includes:
in a first time period: controlling the adjustable power source to provide an input signal for the oscillator; controlling the oscillator to output an oscillation signal based on the input signal; outputting a first control voltage to the adjustable power source based on an amplitude of the oscillation signal and a reference voltage, where the first control voltage is used to control the adjustable power source to adjust the input signal; and controlling the voltage control circuit to obtain a target control voltage, where the target control voltage is the first control voltage presenting when the amplitude of the oscillation signal of the oscillator is stabilized in the first time period; and
after the first time period: controlling the voltage control circuit to control, by using the target control voltage, the adjustable power source to adjust the input signal.

In a possible implementation, outputting the first control voltage to the adjustable power source based on the amplitude of the oscillation signal and the reference voltage includes: outputting an amplitude voltage based on the amplitude of the oscillation signal; and outputting the first control voltage based on a difference between the amplitude voltage and the reference voltage.

In a possible implementation, the voltage control circuit includes a comparison processing circuit, and obtaining the target control voltage includes: comparing the first control voltage with a voltage output by the comparison processing circuit, and outputting a comparison result to the comparison processing circuit; and controlling the comparison processing circuit to determine the target control voltage based on the comparison result.

In a possible implementation, controlling the comparison processing circuit to determine the target control voltage based on the comparison result includes: controlling the comparison processing circuit to output a first digital signal based on the comparison result, where a value of the first digital signal indicates a value of the target control voltage; and outputting the target control voltage based on the first digital signal.

According to a third aspect, an embodiment of this application further provides a phase-locked loop circuit, where the phase-locked loop circuit includes the oscillation circuit described in the first aspect.

According to a fourth aspect, an embodiment of this application further provides an electronic device, where the electronic device includes a circuit board and the phase-locked loop circuit described in the third aspect, and the phase-locked loop circuit is disposed on the circuit board.

According to a fifth aspect, an embodiment of this application further provides a chip system. The chip system includes at least one processor and at least one interface circuit. The at least one processor and the at least one interface circuit may be interconnected through a line. The processor is configured to support the chip system in implementing functions or steps in the method described in the second aspect. The at least one interface circuit may be configured to receive a signal from another apparatus (for example, a memory) or send a signal to another apparatus (for example, a communication interface). The chip system may include a chip, and may further include another discrete component.

According to a sixth aspect, an embodiment of this application further provides a computer-readable storage medium. The computer-readable storage medium includes instructions. When the instructions are run on the electronic device described in the fourth aspect or the chip system described in the fifth aspect, the electronic device or the chip system is enabled to perform the method described in the second aspect.

For related technical effects of the second aspect, the third aspect, the fourth aspect, the fifth aspect, and the sixth aspect, refer to related descriptions of the first aspect. Therefore, details are not described again.

### BRIEF DESCRIPTION OF DRAWINGS

FIG. 1 is a diagram of a structure of an electronic device according to an embodiment of this application;
FIG. 2 is a diagram of a structure of a phase-locked loop circuit according to an embodiment of this application;
FIG. 3 is a diagram of a structure of another phase-locked loop circuit according to an embodiment of this application;
FIG. 4 is a diagram of a structure of another phase-locked loop circuit according to an embodiment of this application;
FIG. 5 is a diagram of a structure of an oscillation circuit according to an embodiment of this application;
FIG. 6 is a diagram of a structure of another oscillation circuit according to an embodiment of this application;
FIG. 7 is a diagram of a structure of another oscillation circuit according to an embodiment of this application;
FIG. 8 is a diagram of a structure of another oscillation circuit according to an embodiment of this application;
FIG. 9 is a diagram of a structure of another oscillation circuit according to an embodiment of this application;
FIG. 10 is a diagram of a structure of another oscillation circuit according to an embodiment of this application;
FIG. 11 is a diagram of a structure of another oscillation circuit according to an embodiment of this application;
FIG. 12 is a diagram of a structure of another oscillation circuit according to an embodiment of this application;
FIG. 13 is a diagram of a structure of another oscillation circuit according to an embodiment of this application;
FIG. 14 is a schematic flowchart of an oscillation control method according to an embodiment of this application;
FIG. 15 is a schematic flowchart of another oscillation control method according to an embodiment of this application;
FIG. 16 is a schematic flowchart of another oscillation control method according to an embodiment of this application; and
FIG. 17 is a diagram of a structure of a chip system according to an embodiment of this application.

### DESCRIPTION OF EMBODIMENTS

It should be noted that the terms "first", "second", and the like in embodiments of this application are merely used to distinguish between features of a same type, and cannot be understood as an indication of relative importance, a quantity, a sequence, or the like.

The term "example", "for example", or the like in embodiments of this application is used to give an example, an illustration, or a description. Any embodiment or design scheme described as an "example" or "for example" in this application should not be explained as being more preferred or having more advantages than another embodiment or design scheme. To be precise, use of the term "example", "for example", or the like is intended to present a related concept in a specific manner.

The terms "coupling" and "connection" in embodiments of this application should be understood in a broad sense. For example, "connection" may be a physical direct connection, or may be an indirect connection implemented through an electronic component, for example, a connection implemented through a resistor, an inductor, a capacitor, or another electronic component.

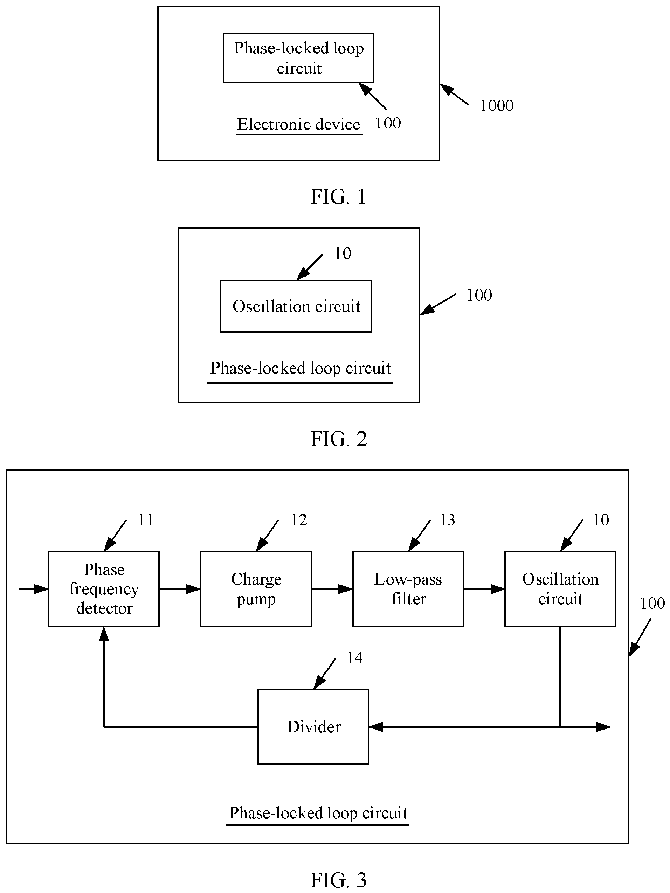

An embodiment of this application provides an electronic device. As shown in FIG. 1, the electronic device 1000 includes a circuit board, and a phase-locked loop (phase-locked loop, PLL) circuit 100 is disposed on the circuit board. As shown in FIG. 2, an oscillation circuit 10 is disposed on the phase-locked loop circuit 100.

For example, the electronic device 1000 may be a communication device such as a point-to-point communication device, a base station communication device, a terminal communication device, a Bluetooth communication device, or a wireless local area network (wireless fidelity, Wi-Fi) communication device.

For example, as shown in FIG. 3, the phase-locked loop circuit 100 may be a charge-pump phase-locked loop (charge-pump phase-locked loop, CPPLL). The charge-pump phase-locked loop includes an oscillation circuit 10, a phase frequency detector (Phase Frequency Detector, PFD) 11, a charge pump (charge pump, CP) 12, a low-pass filter (Low-Pass Filter, LPF) 13, and a divider 14. Optionally, the oscillation circuit 10 may include a voltage-controlled oscillator (voltage-controlled oscillator, VCO).

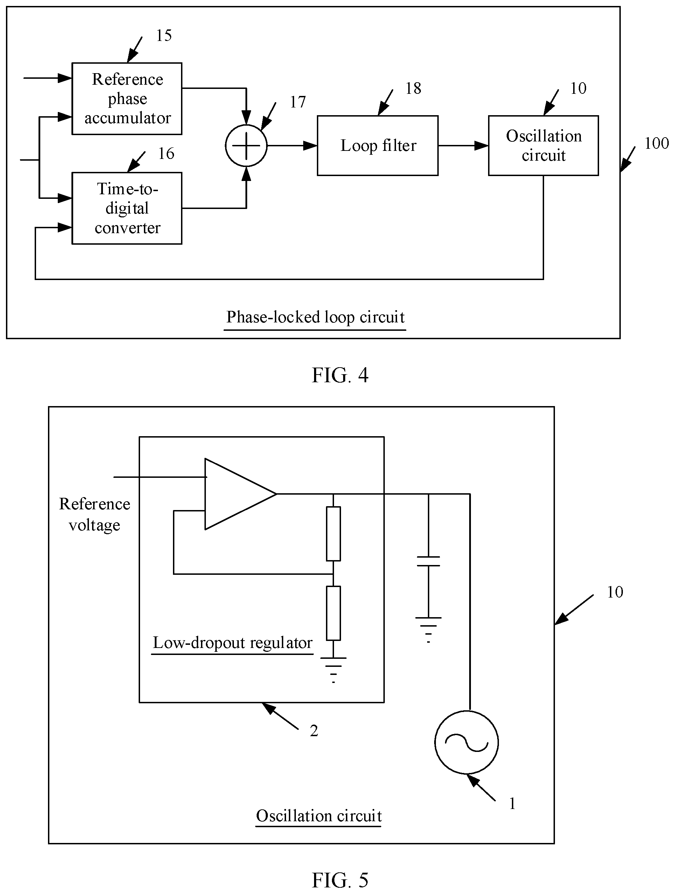

For example, as shown in FIG. 4, the phase-locked loop circuit 100 may be an all-digital phase-locked loop (all-digital phase-locked loop, ADPLL). The phase-locked loop circuit 100 includes an oscillation circuit 10, a reference phase accumulator (reference phase accumulator, RPA) 15, a time-to-digital converter (time-to-digital converter, TDC) 16, a phase detector 17, and a loop filter (Loop filter, LP) 18. The reference phase accumulator 15 is configured to input a frequency control word (frequency control word, FCW) and a reference signal FREF. Optionally, the oscillation circuit 10 may include a digitally controlled oscillator (digitally controlled oscillator, DCO).

An embodiment of this application provides an oscillation circuit. As shown in FIG. 5, the oscillation circuit 10 includes an oscillator (oscillator) 1 and a low-dropout regulator (low-dropout regulator, LDO) 2. The low-dropout regulator 2 outputs a fixed power supply voltage to the oscillator 1 in an open-loop power supply manner, to supply power to the oscillator 1.

In this embodiment of this application, a startup gain of the oscillator 1 varies greatly with different processes, voltages, temperatures (process, voltage, temperature, PVT) and the like for producing the oscillator 1. Consequently, it takes a relatively long time for the oscillator 1 to stabilize to a frequency onto which the phase-locked loop circuit 100 needs to be locked. Besides, an amplitude of an oscillation signal output by the oscillator 1 varies greatly with different PVTs, and the greatly varying amplitude also increases difficulty in designing a next-stage circuit. In addition, there is a risk that the oscillator 1 does not oscillate under some extreme corners (corners).

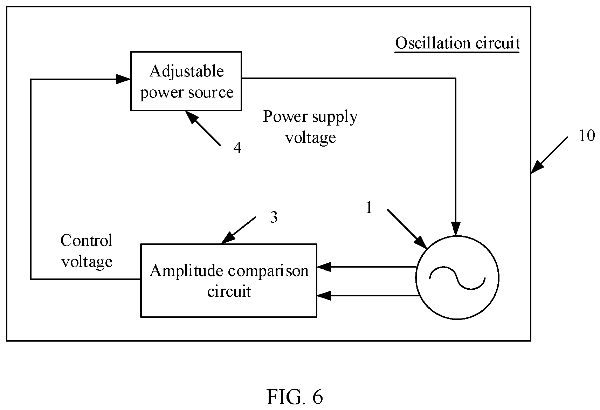

To resolve the problem that the amplitude of the oscillation signal of the oscillator 1 varies greatly with different PVTs, an embodiment of this application further provides an oscillation circuit. As shown in FIG. 6, the oscillation circuit 10 includes an oscillator 1, an amplitude comparison circuit 3, and an adjustable power source 4. The adjustable power source 4 is configured to provide an input signal for the oscillator 1. The oscillator 1 is configured to output an oscillation signal based on the input signal. The amplitude comparison circuit 3 is configured to: detect an amplitude of the oscillation signal output by the oscillator 1, and generate a control voltage based on the amplitude, to adjust, by using the control voltage, a power supply voltage output by the adjustable power source 4, so that the amplitude of the oscillation signal output by the oscillator 1 is stabilized at a fixed amplitude in a closed-loop power supply manner.

In this embodiment of this application, the amplitude of the oscillation signal output by the oscillator 1 is detected, and the power supply voltage output by the adjustable power source 4 is adjusted based on the amplitude. As a result, an amplitude of the oscillator 1 remains stabilized at a fixed amplitude under different PVTs, and therefore the oscillator 1 is stabilized at a relatively fixed frequency. In addition, difficulty in designing a next-stage circuit is reduced, and a risk that the oscillator 1 does not oscillate under extreme corners is avoided. However, in this embodiment of this application, each time the oscillator is powered on or off or when a PVT varies, due to variation of the amplitude, an entire closed-loop power supply circuit needs time to be re-stabilized. This increases stabilization time of the oscillator 1, affecting fast locking time of the entire phase-locked loop circuit 100.

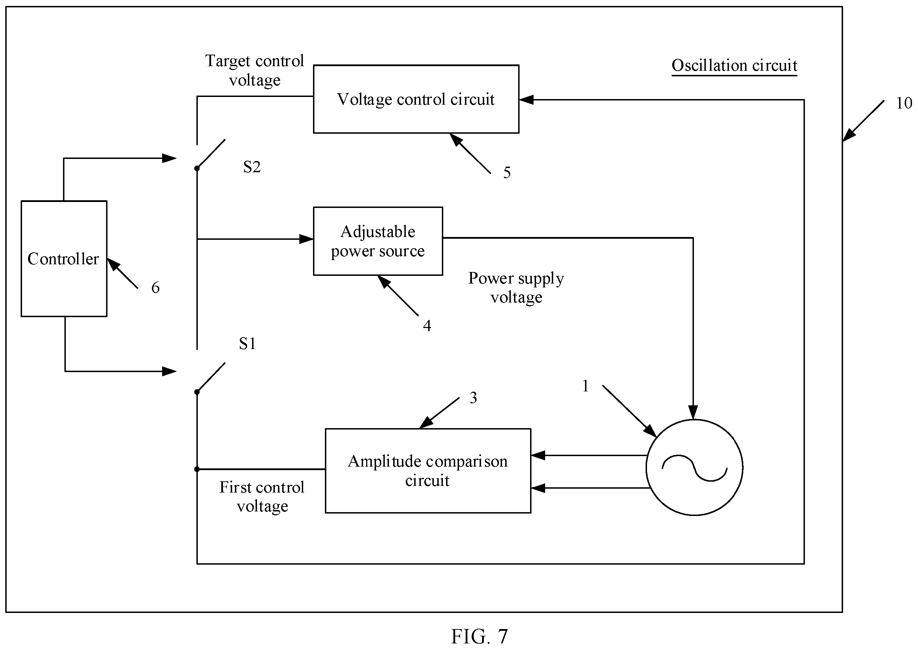

To resolve a problem that the amplitude of the oscillator 1 is unstable in an open-loop power supply case and the stabilization time is excessively long in a closed-loop power supply case, an embodiment of this application further provides an oscillation circuit. As shown in FIG. 7, the oscillation circuit 10 includes an oscillator 1, an amplitude comparison circuit 3, an adjustable power source 4, a voltage control circuit 5, a controller 6, a first switch S1, and a second switch S2. An output of the adjustable power source 4 is coupled to an input of the oscillator 1. An output of the oscillator 1 is coupled to an input of the amplitude comparison circuit 3. An output of the amplitude comparison circuit 3 is coupled to a controlled end of the adjustable power source 4 through the first switch S1. An input of the voltage control circuit 5 is coupled to the output of the amplitude comparison circuit 3. An output of the voltage control circuit 5 is coupled to the controlled end of the adjustable power source 4 through the second switch S2.

The adjustable power source 4 is configured to provide an input signal for the oscillator 1. The oscillator 1 is configured to output an oscillation signal based on the input signal.

In a first time period, the first switch S1 is controlled to be turned on and the second switch S2 is controlled to be turned off. In this case:
the amplitude comparison circuit 3 is configured to output a first control voltage to the adjustable power source 4 through the turned-on first switch S1 based on an amplitude of the oscillation signal output by the oscillator 1, where the first control voltage is used to control the adjustable power source 4 to adjust the input signal output to the oscillator 1; and
the voltage control circuit 5 is configured to obtain a target control voltage, where the target control voltage is the first control voltage presenting when the amplitude of the oscillation signal output by the oscillator 1 is constant.

After the first time period, the first switch S1 is controlled to be turned off and the second switch S2 is controlled to be turned on. In this case:
The voltage control circuit is configured to output the target control voltage to the adjustable power source 4 through the turned-on second switch S2.

For example, that the amplitude of the oscillation signal output by the oscillator 1 is constant means that a variation of the output amplitude of the oscillator 1 is stabilized within a specific variation interval, a variation of a peak of the amplitude of the oscillator 1 is less than a specific value, and a variation of a trough of the amplitude of the oscillator 1 is less than a specific value. In this case, it may be considered that the amplitude is constant.

Optionally, the input signal provided by the adjustable power source 4 may be a power supply voltage or a power supply current.

For example, in the first time period, the controller 6 controls the first switch S1 to be turned on and controls the second switch S2 to be turned off. In this case, the amplitude comparison circuit 3 controls, in a closed-loop power supply manner, the adjustable power source 4 to output a power supply voltage to the oscillator 1, which is specifically: The amplitude comparison circuit 3 obtains the amplitude of the oscillation signal output by the oscillator 1, adjusts a voltage value of the output first control voltage based on the amplitude of the oscillation signal output by the oscillator 1, and adjusts, by using the first control voltage, a value of the power supply voltage output by the adjustable power source 4, until the amplitude of the oscillation signal output by the oscillator 1 is constant. In this case, the first control voltage is the target control voltage. Then, the controller 6 controls the voltage control circuit 5 to obtain the first control voltage that is correspondingly the target control voltage. After the first time period, the controller 6 controls the first switch S1 to be turned off and controls the second switch S2 to be turned on. When the oscillator 1 is powered on or off or a PVT varies subsequently, the voltage control circuit 5 controls, in an open-loop power supply manner, the adjustable power source 4 to output the power supply voltage to the oscillator 1, which is specifically: The voltage control circuit 5 controls, based on the obtained target control voltage by using the constant target control voltage, the voltage value of the power supply voltage output by the adjustable power source 4 to the oscillator 1.

In this embodiment of this application, when the oscillator 1 oscillates to operate for the first time, in the first time period from start of operation, the amplitude of the oscillation signal output by the oscillator 1 is obtained in the closed-loop power supply manner, to obtain the first control voltage that is the target control voltage. The first control voltage causes the adjustable power source 4 to output the power supply voltage to the oscillator 1. The power supply voltage causes the amplitude of the oscillation signal output by the oscillator 1 to be constant. Then, the voltage control circuit 5 obtains the target control voltage. After the first time period, during subsequent operation of the oscillator 1, the voltage control circuit 5 controls, by using the constant target control voltage, the adjustable power source 4 to generate the power supply voltage, to drive the oscillator 1 by using the power supply voltage. Due to the power supply voltage generated by using the target control voltage, there is no need to repeatedly determine the power supply voltage in the closed-loop power supply manner during subsequent operation of the oscillator 1, to stabilize the amplitude of the oscillation signal output by the oscillator 1 at a specific amplitude or within a specific amplitude range. In this embodiment of this application, in this implementation, when the amplitude of the oscillation signal output by the oscillator 1 is relatively stable, the oscillator 1 can be rapidly stabilized, so that a phase-locked loop circuit 100 can also be rapidly locked.

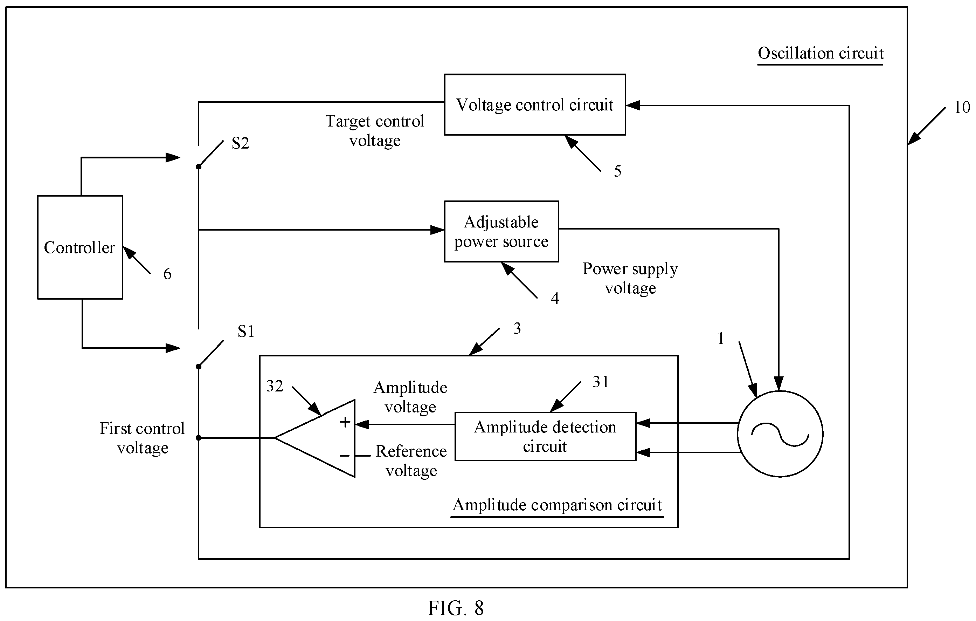

In some possible implementations, as shown in FIG. 8, the amplitude comparison circuit 3 includes an amplitude detection circuit 31 and a first operational amplifier 32, an input of the amplitude detection circuit 31 is coupled to the output of the oscillator 1, an output of the amplitude detection circuit 31 is coupled to a first input of the first operational amplifier 32, a second input of the first operational amplifier 32 is configured to input a reference voltage, and an output of the first operational amplifier 32 is coupled to the controlled end of the adjustable power source 4 through the first switch S1. In the first time period, the amplitude detection circuit 31 is configured to generate an amplitude voltage based on the amplitude of the oscillation signal output by the oscillator 1. The first operational amplifier 32 is configured to: when the amplitude voltage is equal to the reference voltage, generate the first control voltage that is the target control voltage.

In this embodiment of this application, in the first time period, the amplitude detection circuit 31 detects the amplitude of the oscillation signal output by the oscillator 1, and generates the corresponding amplitude voltage based on a value of the amplitude. Next, the amplitude voltage and the reference voltage are input to the first operational amplifier 32, and the first operational amplifier 32 compares a value of the amplitude voltage with a value of the reference voltage. When the amplitude voltage is equal to or close to the reference voltage (which indicates that the amplitude in this case is a required amplitude), the first operational amplifier 32 generates the first control voltage. The adjustable power source 4 is controlled based on the first control voltage to generate the power supply voltage, to supply power to the oscillator 1 at the power supply voltage, so that the amplitude of the oscillation signal output by the oscillator 1 is stabilized. Then, the voltage control circuit 5 obtains the first control voltage. The first control voltage is the target control voltage.

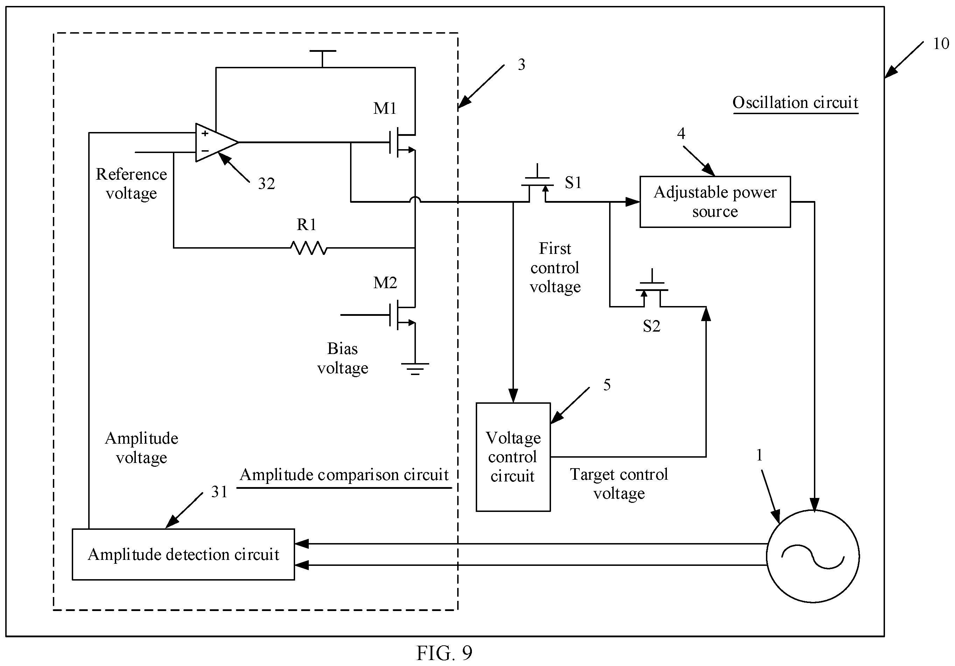

In some possible implementations, as shown in FIG. 9, the amplitude comparison circuit 3 further includes a gain adjustment circuit, the gain adjustment circuit includes a first transistor M1, a second transistor M2, and a first resistor R1, a first electrode of the first transistor M1 is coupled to a voltage end of the first operational amplifier 32, a gate of the first transistor M1 is coupled to the output of the first operational amplifier 32, a second electrode of the first transistor M1 is coupled to the second input of the first operational amplifier 32 through the first resistor R1, a first electrode of the second transistor M2 is coupled to the second electrode of the first transistor M1, a gate of the second transistor M2 is connected to a bias voltage, and a second electrode of the second transistor M2 is grounded.

In this embodiment of this application, an output gain of the first operational amplifier 32 is adjusted through the first transistor M1, so that a gain of the amplitude comparison circuit 3 is improved. A negative feedback level value of the first operational amplifier 32 is adjusted through the second transistor M2 and the first resistor R1.

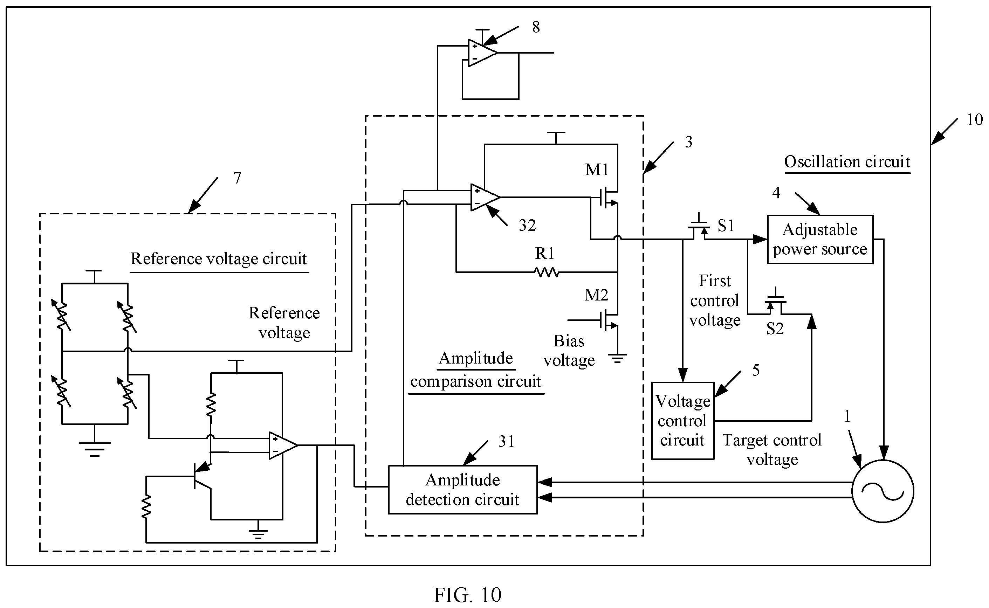

In some possible implementations, as shown in FIG. 10, the oscillation circuit 10 further includes a reference voltage circuit 7, the reference voltage circuit 7 is coupled to the second input of the first operational amplifier 32, and the reference voltage circuit 7 is configured to generate the reference voltage.

In this embodiment of this application, the reference voltage circuit 7 generates the reference voltage, and outputs the reference voltage to the second output of the first operational amplifier 32. A parameter of the reference voltage circuit 7 is adjusted, so that the reference voltage can be adjusted and therefore the amplitude and the like of the oscillation signal output by the oscillator 1 can be adjusted.

In some possible implementations, as shown in FIG. 10, the oscillation circuit 10 further includes a test operational amplifier 8, a first input of the test operational amplifier 8 is coupled to the output of the amplitude detection circuit 31, and a second input of the test operational amplifier 8 is coupled to an output of the test operational amplifier 8.

In this embodiment of this application, some additional test functions for the circuit may be implemented through the test operational amplifier 8.

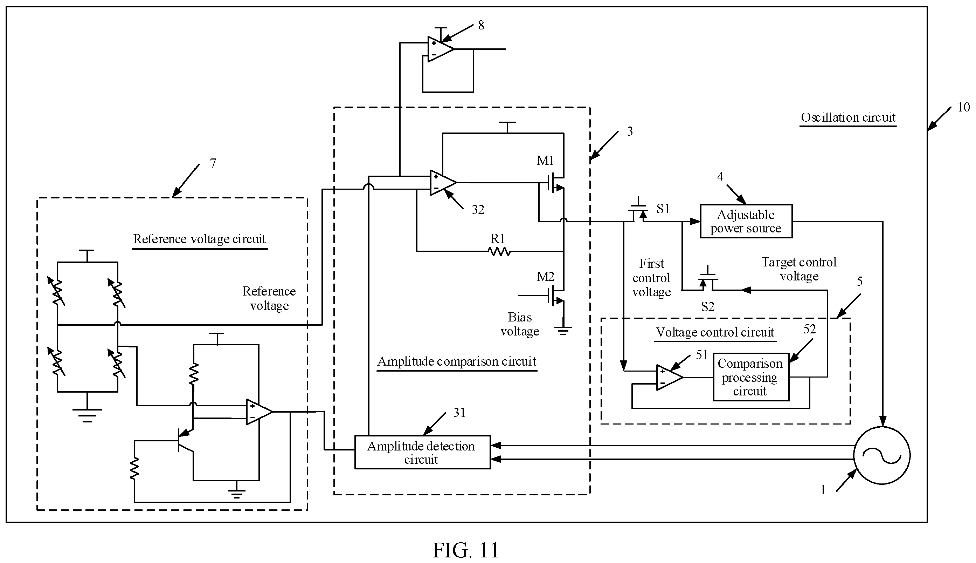

In some possible implementations, as shown in FIG. 11, the voltage control circuit 5 includes a second operational amplifier 51 and a comparison processing circuit 52, a first input of the second operational amplifier 51 is coupled to the output of the amplitude comparison circuit 31, a second input of the second operational amplifier 51 is coupled to an output of the comparison processing circuit 52, an output of the second operational amplifier 51 is coupled to an input of the comparison processing circuit 52, and the output of the comparison processing circuit 52 is coupled to the controlled end of the adjustable power source 4 through the second switch S2. In the first time period: the second operational amplifier 51 is configured to: compare the first control voltage with a voltage output by the comparison processing circuit 52, and output a comparison result to the comparison processing circuit 52; and the comparison processing circuit 52 is configured to determine the target control voltage based on the comparison result.

In this embodiment of this application, the second operational amplifier 51 obtains the first control voltage output by the amplitude comparison circuit 31 and the voltage output by the comparison processing circuit 52; compares, based on set timing, the first control voltage with the voltage output by the comparison processing circuit 52; and outputs a plurality of comparison results to the comparison processing circuit 52 based on the timing. In the comparison processing circuit 52, a corresponding voltage value is set for each comparison operation based on the timing, and it may be determined, based on the input comparison result, a value of the target control voltage corresponding to the comparison result under the corresponding timing. For example, comparison results are 0000000111111, each comparison operation corresponds to a corresponding voltage value, and a voltage value corresponding to a first occurrence of a comparison result of 1 is the voltage value corresponding to the target control voltage; or comparison results are 11111110000000, and a voltage value corresponding to a first occurrence of a comparison result of 0 is the voltage value corresponding to the target control voltage.

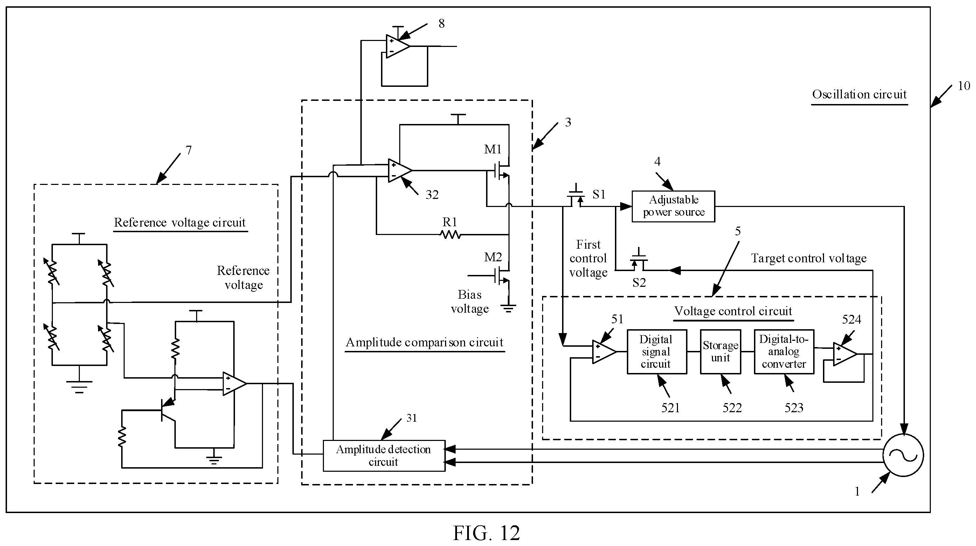

In some possible implementations, as shown in FIG. 12, the comparison processing circuit includes a digital signal circuit 521, a storage unit 522, a digital-to-analog converter 523, and a third operational amplifier 524, an input of the digital signal circuit 521 is coupled to the output of the second operational amplifier 51, an output of the digital signal circuit 521 is coupled to a storage end of the storage unit 522, an output of the storage unit 522 is coupled to an input of the digital-to-analog converter 523, an output of the digital-to-analog converter 523 is coupled to a first input of the third operational amplifier 524, and an output of the third operational amplifier 524 is coupled to the controlled end of the adjustable power source 4 through the second switch S2. In the first time period: the digital signal circuit 521 is configured to output a first digital signal to the storage unit 522 based on the comparison result, where a value of the first digital signal indicates a value of the target control voltage; the storage unit 522 is configured to store the first digital signal; and the digital-to-analog converter 523 is configured to output the target control voltage based on the first digital signal.

For example, the storage unit 522 may be a memory, a buffer, a register, and the like.

In this embodiment of this application, in the first time period, the digital signal circuit 521 determines the voltage value of the target control voltage based on the comparison result, and outputs the first digital signal to the storage unit 522; and the first digital signal indicates the voltage value of the target control voltage, and is input to the storage unit 522 for storage. Then, during subsequent operation of the oscillator 1 (that is, after the first time period), the storage unit 522 outputs the stored first digital signal to the digital-to-analog converter 523, and the digital-to-analog converter 523 outputs the target control voltage. When the oscillator 1 is powered on again or the PVT varies, the digital-to-analog converter 523 controls, based on the output target control voltage, the adjustable power source 4 to output the power supply voltage. In this process, the third operational amplifier 524 may form a voltage follower to stabilize the target control voltage output by the digital-to-analog converter 523.

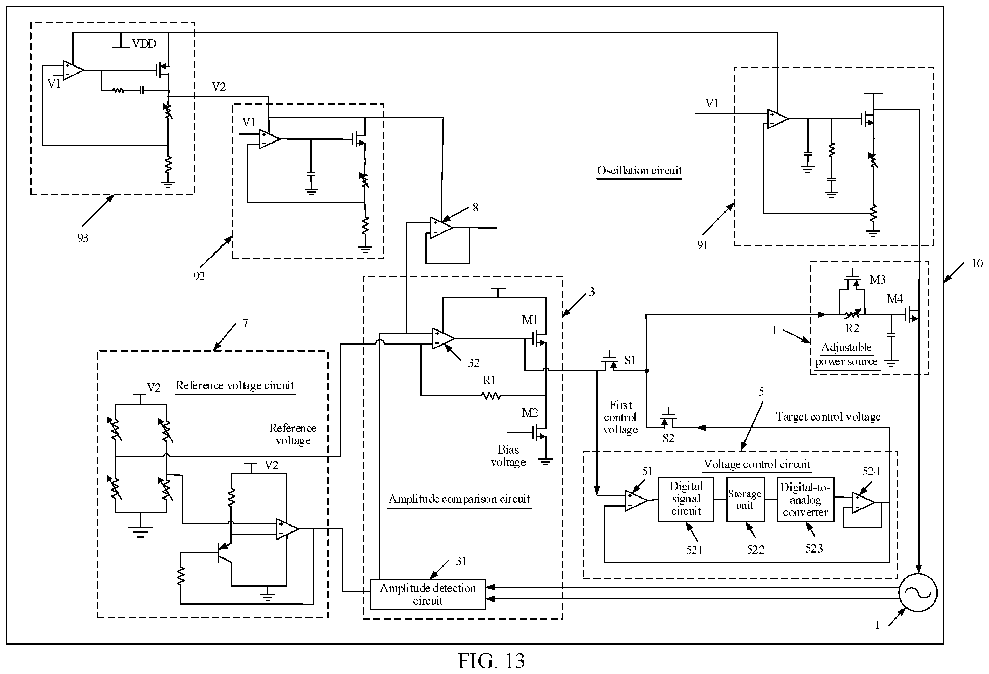

In some possible implementations, as shown in FIG. 13, the adjustable power source 4 includes a third transistor M3, a fourth transistor M4, and a first adjustable resistor R2; a first end of the first adjustable resistor R2 is separately coupled, as the controlled end of the adjustable power source 4, to the first switch S1 and the second switch S2; a second end of the first adjustable resistor R2 is coupled to a gate of the fourth transistor M4; a first electrode of the fourth transistor M4 is configured to input a power supply voltage; a second electrode of the fourth transistor M4 is coupled to the input of the oscillator 1; a first end of the third transistor M3 is coupled to the first end of the first adjustable resistor R2; and a second end of the third transistor M3 is coupled to the second end of the first adjustable resistor R2.

In this embodiment of this application, different first control voltages or target control voltages are output to the first end of the first adjustable resistor R2, so that the power supply voltage output to the oscillator 1 through the first electrode and the second electrode of the fourth transistor M4 has different voltage values. In this way, the power supply voltage is adjusted.

In some possible implementations, as shown in FIG. 13, the oscillation circuit 10 further includes a power supply circuit.

For example, the power supply circuit includes a first power supply circuit 91, the first power supply circuit 91 is coupled to the first electrode of the fourth transistor M4, and the first power supply circuit 91 is configured to provide the power supply voltage.

In this embodiment of this application, the first power supply circuit 91 provides the power supply voltage for the adjustable power source 4.

For example, the power supply circuit further includes a second power supply circuit 92, a third power supply circuit 93, and the like.

In this embodiment of this application, the second power supply circuit 92, the third power supply circuit 93, and the like supply power to the reference voltage circuit 7 and the like.

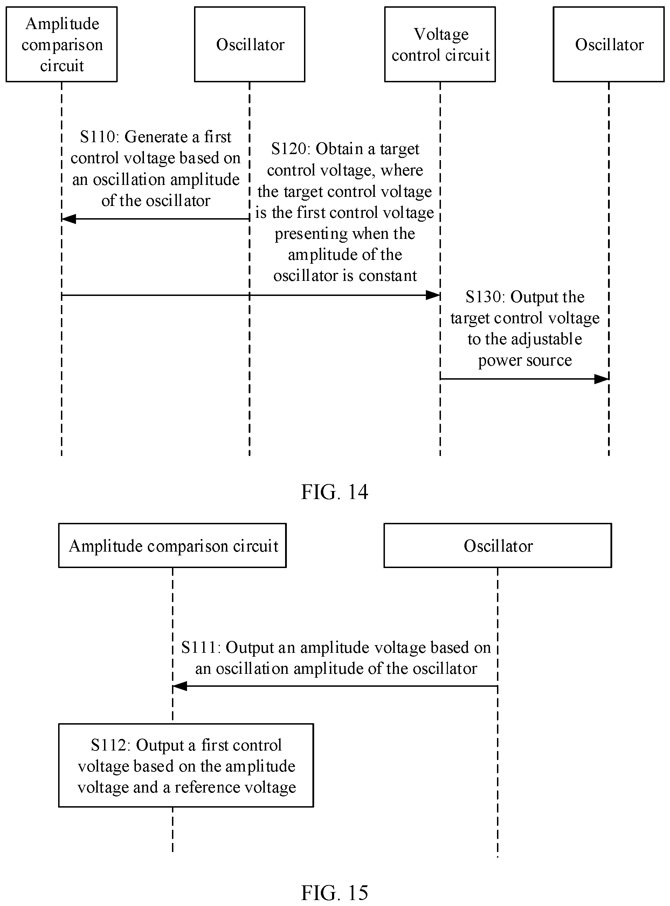

The oscillation circuit including the structures in FIG. 7, FIG. 8, FIG. 9, FIG. 10, FIG. 11, FIG. 12, and FIG. 13 may be configured to perform the following oscillation control method including step S110 to step S130 shown in FIG. 14.

### In a first time period:

Step S110: Generate a first control voltage based on an amplitude of an oscillation signal output by the oscillator 1.

In some possible implementations, the first control voltage is output to the adjustable power source 4 based on an amplitude output by the oscillator 1, where the first control voltage is used to control the adjustable power source 4 to output a power supply voltage to the oscillator 1.

For example, as shown in FIG. 7, the controller 6 controls the first switch S1 to be turned on and controls the second switch S2 to be turned off. In this case, the amplitude comparison circuit 3 controls, in a closed-loop power supply manner, the adjustable power source 4 to output the power supply voltage to the oscillator 1, which is specifically: The amplitude comparison circuit 3 obtains the amplitude of the oscillation signal output by the oscillator 1, adjusts a voltage value of the output first control voltage based on the amplitude of the oscillation signal output by the oscillator 1, and adjusts, by using the first control voltage, a value of the power supply voltage output by the adjustable power source 4, until the amplitude of the oscillation signal output by the oscillator 1 is constant. In this case, the power supply voltage is the power supply voltage.

Specifically, step S110 may include step S111 and step S112 shown in FIG. 15.

Step S111: Output an amplitude voltage based on the amplitude of the oscillation signal output by the oscillator 1.

For example, as shown in FIG. 8, the amplitude detection circuit 31 detects the amplitude of the oscillation signal output by the oscillator 1, and generates the corresponding amplitude voltage based on a value of the amplitude.

Step S112: Output the first control voltage based on the amplitude voltage and a reference voltage.

For example, as shown in FIG. 8, the amplitude voltage and the reference voltage are input to the first operational amplifier 32, and the first operational amplifier 32 compares a value of the amplitude voltage with a value of the reference voltage. When the amplitude voltage is equal to or close to the reference voltage (which indicates that the amplitude in this case is a required amplitude), the first operational amplifier 32 generates the first control voltage. The adjustable power source 4 is controlled based on the first control voltage to generate the power supply voltage, to supply power to the oscillator 1 at the power supply voltage, so that the amplitude of the oscillation signal output by the oscillator 1 is stabilized.

For example, as shown in FIG. 10, the reference voltage circuit 7 generates the reference voltage, and outputs the reference voltage to the second output of the first operational amplifier 32. A parameter of the reference voltage circuit 7 is adjusted, so that the reference voltage can be adjusted and therefore the amplitude and the like of the oscillation signal output by the oscillator 1 can be adjusted.

Step S120: Obtain a target control voltage, where the target control voltage is the first control voltage presenting when the amplitude of the oscillation signal output by the oscillator 1 is constant.

For example, as shown in FIG. 7, the controller 6 controls the voltage control circuit 5 to obtain the corresponding first control voltage presenting when the amplitude of the oscillation signal output by the oscillator 1 is constant, that is, the target control voltage. The controller 6 controls the first switch S1 to be turned off and controls the second switch S2 to be turned on. When the oscillator 1 is powered on or off or a PVT varies subsequently, the voltage control circuit 5 controls, in an open-loop power supply manner, the adjustable power source 4 to output the power supply voltage to the oscillator 1, which is specifically: The voltage control circuit 5 generates the target control voltage based on the obtained first control voltage.

For example, as shown in FIG. 11, the second operational amplifier 51 obtains the first control voltage that is output by the amplitude comparison circuit 31 and that is the target control voltage. The second operational amplifier 51 compares the obtained target control voltage with a voltage output by the comparison processing circuit 52, and outputs a comparison result to the comparison processing circuit 52. The comparison processing circuit 52 determines, based on the comparison result, a voltage value of the first control voltage that is the target control voltage, and stores the voltage value.

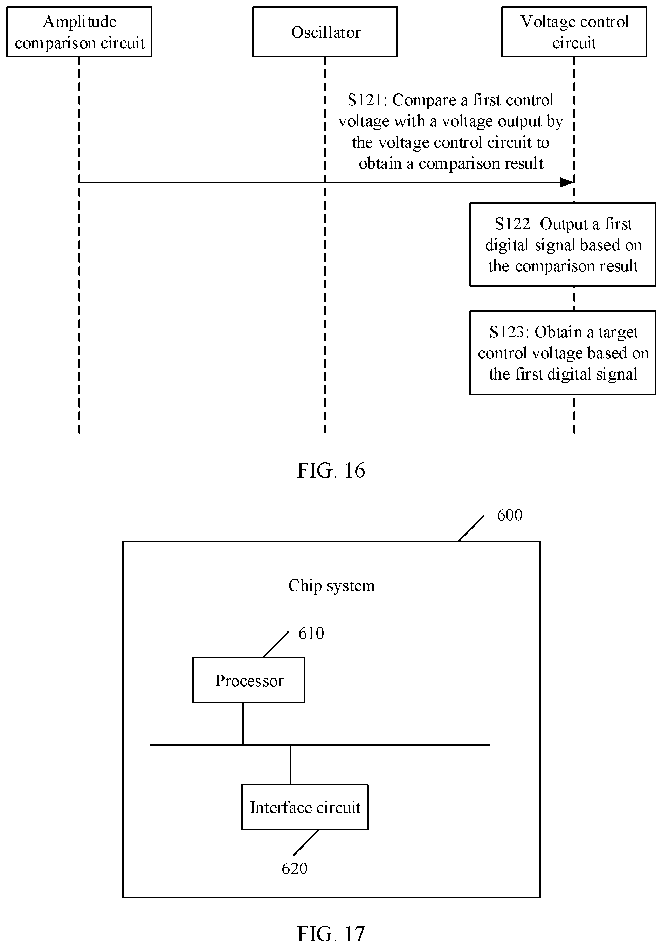

Specifically, step S120 may include step S121 to step S123 shown in FIG. 16.

Step S121: Compare the first control voltage with a voltage output by the voltage control circuit 5 to obtain a comparison result.

For example, as shown in FIG. 7, when the controller 6 controls the first switch S1 to be turned on and controls the second switch S2 to be turned off, power supply control is performed based on the amplitude comparison circuit 3 in the closed-loop power supply manner. In this case, the voltage control circuit 5 obtains the first control voltage output by the amplitude comparison circuit 3 in a process from start of oscillation to stabilization of oscillation of the oscillator 1, and compares the first control voltage with the voltage output by the voltage control circuit 5.

Step S122: Output a first digital signal based on the comparison result.

For example, as shown in FIG. 12, the second operational amplifier 51 obtains the first control voltage output by the amplitude comparison circuit 31 and the voltage output by the comparison processing circuit 52; compares, based on set timing, the first control voltage with the voltage output by the comparison processing circuit 52; and outputs a plurality of comparison results to the comparison processing circuit 52 based on the timing. In the comparison processing circuit 52, a corresponding voltage value is set for each comparison operation based on the timing, and it may be determined, based on the input comparison result, a value of the target control voltage corresponding to the comparison result under the corresponding timing. For example, comparison results are 0000000111111, each comparison operation corresponds to a corresponding voltage value, and a voltage value corresponding to a first occurrence of a comparison result of 1 is the voltage value corresponding to the target control voltage; or comparison results are 11111110000000, and a voltage value corresponding to a first occurrence of a comparison result of 0 is the voltage value corresponding to the target control voltage.

Step S123: Obtain the target control voltage based on the first digital signal.

For example, as shown in FIG. 7, the voltage control circuit 5 obtains the first digital signal based on the comparison result, obtains the target control voltage based on the first digital signal, and outputs the target control voltage to the adjustable power source 4 through the turned-on second switch S2, to control the adjustable power source 4 to output a constant power supply voltage for supplying power to the oscillator 1.

For example, as shown in FIG. 11, the comparison processing circuit 52 obtains the first digital signal based on the comparison result, and generates the target control voltage based on the first digital signal. During subsequent operation (for example, after the first time period), the target control voltage may be output to the adjustable power source 4 through the turned-on second switch S2, to control the adjustable power source 4 to output the constant power supply voltage for supplying power to the oscillator 1.

### After the first time period:

Step S130: Output the target control voltage to the adjustable power source 4.

For example, the target control voltage is stored after the target control voltage is obtained in step S120. After the first time period, the stored target control voltage is read and is directly output.

For example, as shown in FIG. 7, the voltage control circuit 5 obtains the target control voltage based on the first digital signal. After the first time period, the target control voltage is output to the adjustable power source 4 through the turned-on second switch S2, to control the adjustable power source 4 to output the constant power supply voltage for supplying power to the oscillator 1.

For example, as shown in FIG. 11, in the first time period, in step S120, the second operational amplifier 51 obtains the first control voltage that is output by the amplitude comparison circuit 31 and that is the target control voltage. The second operational amplifier 51 compares the obtained target control voltage with the voltage output by the comparison processing circuit 52, and outputs the comparison result to the comparison processing circuit 52. The comparison processing circuit 52 determines, based on the comparison result, the voltage value of the first control voltage that is the target control voltage, and stores the voltage value. After the first time period, the adjustable power source 4 may be controlled, by using the target control voltage, to generate the power supply voltage, and supply power to the oscillator 1 at the constant power supply voltage.

For example, as shown in FIG. 12, the storage unit 522 outputs the stored first digital signal to the digital-to-analog converter 523, and when the oscillator 1 is powered on again or the PVT varies, the digital-to-analog converter 523 generates the target control voltage based on the first digital signal. Then, the third operational amplifier 524 stabilizes the target control voltage and outputs the target control voltage, to control, by using the target control voltage, the adjustable power source 4 to output the power supply voltage.

In some possible implementations, the controller 6 controls the first switch S1 and the second switch S2 to be turned on and turned off based on running time.

For example, the controller 6 performs the operation of step S110 in the first time period, and performs the operation of step S120 after the first time period.

In some possible implementations, the controller 6 may determine, based on a voltage value of the first control voltage output by the amplitude comparison circuit 3, whether the first time period is reached, and perform the operation of step S120.

In some possible implementations, switching from closed-loop power supply to switch power supply (that is, switching from the operations in the first time period to the operations after the first time period) may be performed without using the first switch S1 and the second switch S2, and switching from the operations in the first time period to the operations after the first time period may be implemented in a manner, for example, by controlling, based on timing, whether each component operates.

Embodiments of this application provide an oscillation circuit, an oscillation control method, a phase-locked loop circuit, and an electronic device. An amplitude comparison circuit, a voltage control circuit, an adjustable power source, and an oscillator are disposed in the oscillation circuit. The adjustable power source provides a power supply voltage for the oscillator, and then the amplitude comparison circuit obtains an amplitude of an oscillation signal, and generates a first control voltage based on the amplitude. A value of the power supply voltage output by the adjustable power source is controlled by using the first control voltage, and the amplitude of the oscillation signal is kept constant by using the power supply voltage of a specific value. Then, the voltage control circuit obtains a value of the first control voltage as a target control voltage, and stores the value of the first control voltage. During subsequent operation of the oscillator, the voltage control circuit controls, by using the target control voltage, the adjustable power source to output the power supply voltage, and power is supplied to the oscillator at the power supply voltage. The power supply voltage obtained by using the target control voltage causes the amplitude of the oscillation signal to be kept constant or causes the amplitude of the oscillation signal to be kept within a specific range. According to embodiments of this application, the adjustable power source can be controlled, based on the target control voltage generated by the voltage control circuit, to generate a constant power supply voltage, so that the oscillator is rapidly stabilized. In addition, the amplitude of the oscillator is kept stable or a variation of the amplitude falls within a specific range, when power is supplied at the power supply voltage. In the solutions described in embodiments of this application, an amplitude and an oscillation frequency of the oscillator can be kept relatively stable while the oscillator is rapidly stabilized.

An embodiment of this application further provides a chip system. As shown in FIG. 17, a chip system 600 includes at least one processor 610 and at least one interface circuit 620. The at least one processor 610 and the at least one interface circuit 620 may be interconnected through a line. The processor 610 is configured to support the chip system 600 in implementing functions or steps in the method embodiment, for example, the oscillation control method shown in FIG. 14, FIG. 15, and FIG. 16. The at least one interface circuit 620 may be configured to receive a signal from another apparatus (for example, a memory) or send a signal to another apparatus (for example, a communication interface). The chip system 600 may include a chip, and may further include another discrete component.

An embodiment of this application further provides a computer-readable storage medium. The computer-readable storage medium includes instructions. When the instructions are run on the electronic device or the chip system including the structures shown in FIG. 7, FIG. 8, FIG. 9, FIG. 10, FIG. 11, FIG. 12, and FIG. 13 in the foregoing embodiments, the electronic device or the chip system is enabled to perform the oscillation control method described in FIG. 14, FIG. 15, and FIG. 16.

The processor in embodiments of this application may be a chip. For example, the processor may be a field programmable gate array (field programmable gate array, FPGA), an application-specific integrated chip (application-specific integrated circuit, ASIC), a system on chip (system on chip, SoC), a central processing unit (central processing unit, CPU), a network processor (network processor, NP), a digital signal processing circuit (digital signal processor, DSP), a micro controller unit (micro controller unit, MCU), a programmable controller (programmable logic device, PLD), or another integrated chip.

The memory in embodiments of this application may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). It should be noted that the memory of the systems and method described in this specification includes but is not limited to these and any memory of another proper type.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by the person skilled in the art that, for the purpose of convenient and brief description, for a detailed operation process of the foregoing system, apparatus, and module, refer to a corresponding process in the foregoing method embodiments, and details are not described herein again.

In the several embodiments provided in this application, it should be understood that, the disclosed system, device, and method may be implemented in other manners. For example, the described device embodiments are merely examples. For example, division into the modules is merely logical function division, and may be other division in actual implementation. For example, a plurality of modules or components may be combined or may be integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate components may or may not be physically separate, and components displayed as modules may or may not be physical modules, and may be located in one device or may be distributed on a plurality of devices. Some or all of the modules may be selected according to actual needs to achieve the objectives of the solutions of embodiments.

In addition, functional modules in embodiments of this application may be integrated into one device, or each of the modules may exist alone physically, or two or more modules are integrated into one device.

All or some of the foregoing embodiments may be implemented by using software, hardware, firmware, or any combination thereof. When a software program is used to implement embodiments, embodiments may be implemented completely or partially in a form of a computer program product. The computer program product includes one or more computer instructions. When the computer program instructions are loaded and executed on a computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like.

The foregoing descriptions are merely specific implementations of this application, but are not intended to limit the protection scope of this application. Any variation or replacement readily figured out by the person skilled in the art within the technical scope disclosed in this application shall fall within the protection scope of this application. Therefore, the protection scope of this application shall be subject to the protection scope of the claims.

## Claims

1. An oscillation circuit, comprising an oscillator, an amplitude comparison circuit, a voltage control circuit, and an adjustable power source, wherein the adjustable power source is coupled to the oscillator, the amplitude comparison circuit is separately coupled to the oscillator and the adjustable power source, and the voltage control circuit is separately coupled to the amplitude comparison circuit and the adjustable power source;
the adjustable power source is configured to provide an input signal for the oscillator;
the oscillator is configured to output an oscillation signal based on the input signal;
in a first time period:
the amplitude comparison circuit is configured to output a first control voltage to the adjustable power source based on an amplitude of the oscillation signal and a reference voltage, wherein the first control voltage is used to control the adjustable power source to adjust the input signal; and
the voltage control circuit is configured to obtain a target control voltage, wherein the target control voltage is the first control voltage presenting when the amplitude of the oscillation signal of the oscillator is stabilized in the first time period; and
after the first time period:
the voltage control circuit is configured to control, by using the target control voltage, the adjustable power source to adjust the input signal.

2. The circuit according to claim 1, wherein the amplitude comparison circuit comprises an amplitude detection circuit and a first operational amplifier, an input of the amplitude detection circuit is coupled to an output of the oscillator, an output of the amplitude detection circuit is coupled to a first input of the first operational amplifier, a second input of the first operational amplifier is configured to input a reference voltage, and an output of the first operational amplifier is coupled to a controlled end of the adjustable power source; and
in the first time period:
the amplitude detection circuit is configured to output an amplitude voltage based on the amplitude of the oscillation signal; and
the first operational amplifier is configured to output the first control voltage based on a difference between the amplitude voltage and the reference voltage.

3. The circuit according to claim 2, wherein the amplitude comparison circuit further comprises a gain adjustment circuit, the gain adjustment circuit comprises a first transistor, a first electrode of the first transistor is coupled to a voltage end of the first operational amplifier, a gate of the first transistor is coupled to the output of the first operational amplifier, and a second electrode of the first transistor is coupled to the second input of the first operational amplifier.

4. The circuit according to claim 3, wherein the gain adjustment circuit further comprises a second transistor, a first electrode of the second transistor is coupled to the second electrode of the first transistor, a gate of the second transistor is connected to a bias voltage, and a second electrode of the second transistor is grounded.

5. The circuit according to claim 3 or 4, wherein the gain adjustment circuit further comprises a first resistor, and the second electrode of the first transistor is coupled to the second input of the first operational amplifier through the first resistor.

6. The circuit according to any one of claims 2 to 5, wherein the oscillation circuit further comprises a reference voltage circuit, the reference voltage circuit is coupled to the second input of the first operational amplifier, and the reference voltage circuit is configured to generate the reference voltage.

7. The circuit according to any one of claims 2 to 6, wherein the oscillation circuit further comprises a test operational amplifier, a first input of the test operational amplifier is coupled to the output of the amplitude detection circuit, and a second input of the test operational amplifier is coupled to an output of the test operational amplifier.

8. The circuit according to any one of claims 1 to 7, wherein the voltage control circuit comprises a second operational amplifier and a comparison processing circuit, a first input of the second operational amplifier is coupled to an output of the amplitude comparison circuit, a second input of the second operational amplifier is coupled to an output of the comparison processing circuit, an output of the second operational amplifier is coupled to an input of the comparison processing circuit, and the output of the comparison processing circuit is coupled to the controlled end of the adjustable power source; and
in the first time period:
the second operational amplifier is configured to: compare the first control voltage with a voltage output by the comparison processing circuit, and output a comparison result to the comparison processing circuit; and
the comparison processing circuit is configured to determine the target control voltage based on the comparison result.

9. The circuit according to claim 8, wherein the comparison processing circuit comprises a digital signal circuit, a storage unit, a digital-to-analog converter, and a third operational amplifier, an input of the digital signal circuit is coupled to the output of the second operational amplifier, an output of the digital signal circuit is coupled to a storage end of the storage unit, an output of the storage unit is coupled to an input of the digital-to-analog converter, and an output of the digital-to-analog converter is coupled to the controlled end of the adjustable power source; and
in the first time period:
the digital signal circuit is configured to output a first digital signal to the storage unit based on the comparison result, wherein a value of the first digital signal indicates a value of the target control voltage;
the storage unit is configured to store the first digital signal; and
the digital-to-analog converter is configured to output the target control voltage based on the first digital signal.

10. The circuit according to claim 9, wherein the comparison processing circuit further comprises the third operational amplifier, the output of the digital-to-analog converter is coupled to a first input of the third operational amplifier, an output of the third operational amplifier is coupled to the controlled end of the adjustable power source, and the output of the third operational amplifier is further coupled to a second input of the third operational amplifier.

11. The circuit according to any one of claims 1 to 10, wherein the oscillation circuit further comprises a first switch and a second switch, the amplitude comparison circuit is coupled to the controlled end of the adjustable power source through the first switch, and the voltage control circuit is coupled to the controlled end of the adjustable power source through the second switch;
in the first time period, the first switch is turned on and the second switch is turned off; and
after the first time period, the first switch is turned off and the second switch is turned on.

12. The circuit according to claim 11, wherein the adjustable power source comprises a third transistor, a fourth transistor, and a first adjustable resistor; a first end of the first adjustable resistor is separately coupled, as the controlled end of the adjustable power source, to the first switch and the second switch; a second end of the first adjustable resistor is coupled to a gate of the fourth transistor; a first electrode of the fourth transistor is configured to input a power supply voltage; a second electrode of the fourth transistor is coupled to an input of the oscillator; a first end of the third transistor is coupled to the first end of the first adjustable resistor; and a second end of the third transistor is coupled to the second end of the first adjustable resistor.

13. The circuit according to claim 12, wherein the oscillation circuit further comprises a first power supply circuit, the first power supply circuit is coupled to the first electrode of the fourth transistor, and the first power supply circuit is configured to supply power to the adjustable power source.

14. An oscillation control method, based on an oscillation circuit, wherein the oscillation circuit comprises a voltage control circuit, an oscillator, and an adjustable power source, and the method comprises:
in a first time period:
controlling the adjustable power source to provide the input signal for the oscillator;
controlling the oscillator to output an oscillation signal based on the input signal;
outputting a first control voltage to the adjustable power source based on an amplitude of the oscillation signal and a reference voltage, wherein the first control voltage is used to control the adjustable power source to adjust the input signal; and
controlling the voltage control circuit to obtain a target control voltage, wherein the target control voltage is the first control voltage presenting when the amplitude of the oscillation signal of the oscillator is stabilized in the first time period; and
after the first time period:
controlling the voltage control circuit to control, by using the target control voltage, the adjustable power source to adjust the input signal.

15. The method according to claim 14, wherein outputting the first control voltage to the adjustable power source based on the amplitude of the oscillation signal and the reference voltage comprises:
outputting an amplitude voltage based on the amplitude of the oscillation signal; and
outputting the first control voltage based on a difference between the amplitude voltage and the reference voltage.

16. The method according to claim 14 or 15, wherein the voltage control circuit comprises a comparison processing circuit, and obtaining the target control voltage comprises:
comparing the first control voltage with a voltage output by the comparison processing circuit, and outputting a comparison result to the comparison processing circuit; and
controlling the comparison processing circuit to determine the target control voltage based on the comparison result.

17. The method according to claim 16, wherein controlling the comparison processing circuit to determine the target control voltage based on the comparison result comprises:
controlling the comparison processing circuit to output a first digital signal based on the comparison result, wherein a value of the first digital signal indicates a value of the target control voltage; and
outputting the target control voltage based on the first digital signal.

18. A phase-locked loop circuit, comprising the oscillation circuit according to any one of claims 1 to 13.

19. An electronic device, comprising a circuit board and the phase-locked loop circuit according to claim 18, wherein the phase-locked loop circuit is disposed on the circuit board.

20. A computer-readable storage medium, wherein the computer-readable storage medium comprises instructions, and when the instructions are run on the electronic device according to claim 19, the electronic device is enabled to perform the method according to any one of claims 14 to 17.
